(19) Europäisches Patentamt / European Patent Office / Office européen des brevets

(11) **EP 4 288 304 B1**

(12) **FASCICULE DE BREVET EUROPEEN**

(45) Date de publication et mention
de la délivrance du brevet:
**09.07.2025 Bulletin 2025/28**

(21) Numéro de dépôt: **22703011.1**

(22) Date de dépôt: **04.01.2022**

(51) Classification Internationale des Brevets (IPC):
**B60L 58/12** (2019.01)   **B60L 53/68** (2019.01)
**H01M 10/44** (2006.01)   **H04W 4/024** (2018.01)
**H04W 4/40** (2018.01)   **G01R 31/36** (2020.01)
**H01M 10/00** (2006.01)   **H02J 7/00** (2006.01)
**G07C 5/00** (2006.01)   **H01M 10/48** (2006.01)
**B60L 53/66** (2019.01)

(52) Classification Coopérative des Brevets (CPC):
**B60L 58/12; B60L 53/665; B60L 53/68;**
**H01M 10/44; H01M 10/48; H02J 7/00032;**
**H02J 7/0048; H04W 4/024; H04W 4/40;**
B60L 2240/622; B60L 2260/42; B60L 2260/44;
B60L 2260/52; G01R 31/371; G07C 5/008;   (Cont.)

(86) Numéro de dépôt international:
**PCT/FR2022/050007**

(87) Numéro de publication internationale:
**WO 2022/167735 (11.08.2022 Gazette 2022/32)**

(54) **PROCEDE D'ESTIMATION D'UN ETAT DE CHARGE D'UNE BATTERIE DE VEHICULE ELECTRIFIE POUR UN SYSTEME DE SUPERVISION DISTANTE**

VERFAHREN ZUR SCHÄTZUNG EINES LADEZUSTANDS EINER BATTERIE EINES ELEKTROFAHRZEUGS FÜR FERNÜBERWACHUNGSSYSTEM

METHOD FOR ESTIMATING STATE OF CHARGE OF A BATTERY ONBOARD AN ELECTRIC VEHICLE FOR A REMOTE SUPERVISION SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.02.2021 FR 2101101**

(43) Date de publication de la demande:
**13.12.2023 Bulletin 2023/50**

(73) Titulaire: **Stellantis Auto SAS**
**78300 Poissy (FR)**

(72) Inventeurs:
• **RAMOS DOS SANTOS, Graziele**
**92140 CLAMART (FR)**
• **PETIT, Benjamin**
**92500 RUEIL MALMAISON (FR)**

• **BAGHDADI, Issam**
**78600 LE MESNIL LE ROI (FR)**
• **MERVEILLAUT, Mathieu**
**78210 ST CYR L ECOLE (FR)**

(74) Mandataire: **PSIP**
**Stellantis**
**Service REIP**
**Propriété industrielle - YT800**
**2-10, boulevard de l'Europe**
**78300 Poissy (FR)**

(56) Documents cités:
WO-A2-2010/033517     WO-A2-2013/057587
FR-A1- 3 065 118       US-A1- 2011 193 522
US-A1- 2012 280 653    US-A1- 2019 064 281

(52) Classification Coopérative des Brevets (CPC):
(Cont.)H01M 2220/20; H02J 2310/48; Y02T 10/70;
Y02T 10/7072

## EP 4 288 304 B1

**Description**

La présente invention revendique la priorité de la demande française N°2101101 déposée le 05.02.2021.

Le domaine de l'invention concerne un procédé d'estimation d'un état de charge d'une batterie de véhicule dans le cadre d'une supervision distante de véhicules électrifiés connectés, notamment un système de supervision distante d'une flotte de véhicules permettant la gestion d'une recharge distante.

Les véhicules électrifiés, hybrides et électriques, embarquent des systèmes de batterie de puissance (désignés par l'acronyme anglophone BMS pour « Batterie Management System ») qui sont supervisés par des fonctions de diagnostics visant à conserver un niveau de performance optimal tout au long de la vie du véhicule. Ces fonctions de diagnostic sont complémentées par des nouveaux services distants déportés du véhicule à travers des plateformes logicielles de supervision distante. Les véhicules récents comprennent de nombreux calculateurs embarqués, et pour l'opération de services distants sont équipés de moyens de communication sans fil, communément désigné par le terme boitier télématique, ou les acronymes BTA et BSRF pour « Boitier Télématique Autonome » et « Boitier de servitude radiofréquence », permettant une transmission de données à travers un réseau de communication de téléphonie mobile. Le boitier télématique coopère avec le calculateur principal du véhicule, couramment désigné par l'acronyme anglophone VSM pour « Vehicle Supervisor Module », aussi appelé BSI pour « Boitier de Servitude Intelligent » ou bien encore VCU pour « Vehicle Control Unit ».

D'autre part, certains constructeurs proposent à un utilisateur ou un propriétaire du véhicule des services en ligne permettant un usage du véhicule à travers un dispositif personnel mobile connecté à la plateforme, tel son téléphone portable ou « smartphone » selon le terme anglophone. Par exemple, dans le cas d'un véhicule électrique l'utilisateur souscripteur d'un service a la possibilité de piloter la commande d'une recharge différée et de consulter à distance l'avancement de la recharge en temps réel.

En outre, on connait le document US20170320398A1 décrivant un système de service en ligne embarqué de véhicule automobile permettant d'envoyer des requêtes de recherche de stations de recharge et de retourner à un utilisateur les informations de localisation des stations. On connait le document US20160089994A1 décrivant un véhicule dans lequel le système de batterie embarqué est prévu pour transmettre à un système distant des données d'état permettant un diagnostic des cellules de batterie. On connait également le document FR3065690A1 décrivant un dispositif et procédé d'analyse de données pour la gestion d'une flotte de véhicule.

WO 2010/033517 A2 divulgue procédé d'estimation de l'état de charge d'une batterie électrique d'un véhicule électrifié selon l'état de la technique.

Avec l'essor des véhicules connectés et des nouveaux usages, les services en lignes vont se multiplier, augmentant alors la fréquence des communications entre un véhicule et un serveur distant pour les besoins de la plateforme de supervision distante. Dans le cas d'une recharge différée, on prévoit de planifier les recharges électriques lorsque le tarif est le plus bas ou selon des cycles de recharge pilotés par un opérateur de réseau d'alimentation électrique. Généralement, ce type de recharge s'opère en l'absence de l'utilisateur et le véhicule est donc éteint lors du déclenchement la recharge. Il est donc nécessaire de réveiller le véhicule et ses calculateurs. Il existe des protocoles de communication de données permettant un réveil à distance, par exemple grâce au protocole MQTT « Message Queuing Telemetry Transport ». Le document FR3041782A1 décrit un protocole de réveil d'un calculateur de gestion d'une recharge électrique en fonction d'un signal de contrôle fourni par une borne de recharge.

Pour réveiller les calculateurs, il est nécessaire de les mettre sous tension électrique. C'est le rôle des circuits d'alimentation et commutateurs électriques. Les circuits d'alimentation et les commutateurs électriques sont généralement dimensionnés pour répondre à un certain nombre de commutations journalières. Or, la multiplicité des services et des usages augmente drastiquement la fréquence de ces commutations, en particulier lors de consultations fréquentes de la part d'un utilisateur. Cela entraine un vieillissement accéléré des systèmes télématiques du véhicule. Le boitier télématique par exemple est généralement dimensionné pour une ou deux dizaines de commutations de réveil/arrêt par jour. D'autres systèmes, tel le BMS, ne sont généralement pas non plus dimensionnés pour répondre à un grand nombre de commutations quotidiennement.

Il existe donc un besoin de pallier les problèmes précités. Un objectif de l'invention est de réduire les commutations de réveil et d'arrêt des circuits d'alimentation du boitier télématique et des calculateurs dans le cadre de l'opération de services connectés. Un autre objectif est d'améliorer la qualité des services en ligne et des données de supervision d'un véhicule, en particulier pour les véhicules rechargeables.

Plus précisément, l'invention concerne un procédé d'estimation de l'état de charge d'une batterie électrique d'un véhicule électrifié mis en œuvre dans un système de supervision de véhicules électrifiés comprenant des moyens de recharge électrique reliés à un réseau d'alimentation électrique et assurant une recharge électrique de ladite batterie électrique, au moins un équipement de supervision distante hébergeant un système logiciel de supervision distante de véhicules connectés et un réseau étendu de communication sans fil, le véhicule comprenant un dispositif de communication sans fil adapté pour transmettre des données à l'équipement de supervision distante à travers ledit réseau et un calculateur d'infodivertissement prévu pour la fourniture de paramètres de navigation à bord du véhicule.

Selon l'invention, le procédé comprend :

- En début d'une session de recharge électrique une première communication de données dudit véhicule électrifié vers l'équipement de supervision, ladite première communication de données comprenant des données communiquées incluant des premières valeurs d'un état de charge effectif de ladite batterie et des paramètres de navigation issus du calculateur et représentatifs d'une vitesse de recharge et d'une autonomie résiduelle de roulage à l'instant de ladite première communication,
- Pendant ladite session de recharge électrique, une estimation et une fourniture d'un état de charge estimé par ledit équipement de supervision, ledit état de charge estimé étant déterminé à partir desdites données communiquées et d'une première valeur $\alpha_0$ d'un facteur de correction $\alpha$ de la vitesse de recharge, ladite première valeur $\alpha_0$ étant enregistrée dans une base de données de l'équipement de supervision, l'estimation de l'état de charge estimé étant calculée à partir d'une équation d'estimation égale à la relation [Math 1] donnée ci-dessous.

Selon une variante, les paramètres de navigation incluent une vitesse de recharge dont la valeur est exprimée en autonomie de roulage par heure de recharge et une autonomie résiduelle dont la valeur est exprimée en distance de roulage.

Selon une variante, le procédé comporte en outre, durant la session de recharge électrique, au moins une séquence de recalage de l'état de charge estimé et du facteur de correction $\alpha$ comprenant les étapes successives suivantes :

- Une deuxième communication de données dudit véhicule électrifié vers l'équipement de supervision comprenant des deuxièmes valeurs desdites données communiquées à l'instant de la deuxième communication,
- Le recalage de l'état de charge estimé à partir desdites deuxièmes valeurs,
- Le calcul d'une deuxième valeur $\alpha_k$ du facteur de correction $\alpha$ et la mise à jour de la valeur enregistrée dans la base de données pour des estimations de l'état de charge ultérieurement à l'instant de la deuxième communication.

Selon une variante, au moins ladite séquence de recalage est déclenchée en cas de détection d'une durée de charge écoulée qui est égale à environ à la moitié de la durée de recharge totale planifiée de la session de recharge.

Selon une variante, le procédé comporte en outre en cas de détection d'une fin de la session de recharge :

- Une troisième communication de données dudit véhicule électrifié vers l'équipement de supervision incluant la valeur de l'état de charge effectif de ladite batterie à l'instant de la fin de la session de recharge,
- Le recalage de l'état de charge estimé à partir de ladite valeur de l'état de charge effectif,
- Le calcul d'une troisième valeur $\alpha_n$ du facteur de correction $\alpha$ et la mise à jour de la valeur enregistrée dans la base de données pour des estimations de l'état de charge ultérieurement à l'instant de la fin de session de recharge.

Selon l'invention, l'estimation de l'état de charge estimé est calculée à partir d'une équation d'estimation égale à la relation suivante :

[Math 1]

$$SOC_E(t_n) = SOC_R(t_0) + \alpha * \frac{(t_n - t_0) * CR * SOC_R(t_0)}{AR * 3600}$$

Où:

- $SOC_E(t_n)$ est la valeur estimée de l'état de charge à un instant $t_n$,

- $SOC_R(t_0)$ est la valeur effective collectée par l'équipement de supervision à un instant $t_0$ antérieur à $t_n$,

- $\alpha$ est le facteur de correction enregistrée dans la base de données,

- $CR$ est un paramètre représentatif du courant de charge déterminé à partir de la vitesse de recharge,

- $AR$ est un paramètre représentatif d'une capacité de roulage restante calculé à partir de l'autonomie résiduelle de roulage.

Selon une variante, la session de recharge comporte en outre une phase de pré-conditionnement thermique de la batterie durant laquelle l'équipement de supervision collecte à travers le réseau de communication sans fil des valeurs de l'état de charge effectif de ladite batterie selon une fréquence prédéterminée et/ou en réponse à une requête pour la fourniture desdites valeurs.

Selon une variante, le procédé comporte en outre la fourniture de la valeur de l'état de charge estimé par l'équipement de supervision à un dispositif électronique personnel d'un utilisateur du véhicule à travers le réseau de communication sans fil.

Selon une variante, le procédé comporte en outre la fourniture de la valeur de l'état de charge estimé par l'équipement de supervision à un serveur informatique d'un fournisseur de service tiers.

Il est prévu selon l'invention un équipement de supervision distante comportant un dispositif de stockage de données mémorisant des instructions de programme mettant en œuvre le procédé d'estimation de l'état de charge d'une batterie électrique d'un véhicule électrifié selon l'un quelconque des modes de réalisation précédents.

Il est également prévu un produit programme-ordinateur comprenant des instructions qui, lorsque le programme est exécuté par un calculateur, conduisent celui-ci à mettre en œuvre l'un quelconque des modes de réalisation du procédé d'estimation de l'état de charge d'une batterie électrique d'un véhicule électrifié selon l'un quelconque des modes de réalisation précédents.

L'invention réduit drastiquement le nombre de commutations de réveil des systèmes électroniques du véhicule. Il assure également à un système tiers la fourniture d'une estimation de l'état de charge de manière continue avec une fréquence de mise à jour des données supérieures aux solutions de l'état de la technique. Le procédé selon l'invention améliore l'interopérabilité du système du fait qu'il utilise des données transmissibles par un véhicule quelle que soit l'architecture électrique et réseau de communication de bord du véhicule.

D'autres caractéristiques et avantages de la présente invention apparaitront plus clairement à la lecture de la description détaillée qui suit comprenant des modes de réalisation de l'invention donnés à titre d'exemples nullement limitatifs et illustrés par les dessins annexés, dans lesquels :

[Fig.1] représente un système de supervision distante d'une flotte de véhicule électrifiés apte à mettre en œuvre le procédé selon l'invention.

[Fig.2] représente deux graphiques permettant d'illustrer la réduction des commutations de réveil d'un véhicule connecté grâce au procédé selon l'invention.

[Fig.3] représente un algorithme du procédé d'estimation de l'état de charge d'une batterie de véhicule électrifié selon l'invention.

[Fig.4] représente une courbe montrant une évolution de l'état de charge estimé obtenue par le procédé selon l'invention et l'action de recalage des paramètres d'équations lors d'une session de recharge.

Le procédé d'estimation d'un état de charge selon l'invention est décrit ici dans le cas d'exemple d'une recharge électrique d'un véhicule électrifié, hybride ou électrique, mise en œuvre par un système de supervision distante de véhicules électrifiés utilisant une borne de recharge statique électrique filaire. Néanmoins, on envisage que le procédé selon l'invention s'applique pour d'autres systèmes de recharge, tels les systèmes utilisant des recharges électriques par induction statique ou dynamique. L'invention s'adresse particulièrement aux véhicules automobiles. On envisage également une application pour les véhicules à traction humaine à assistance électrique.

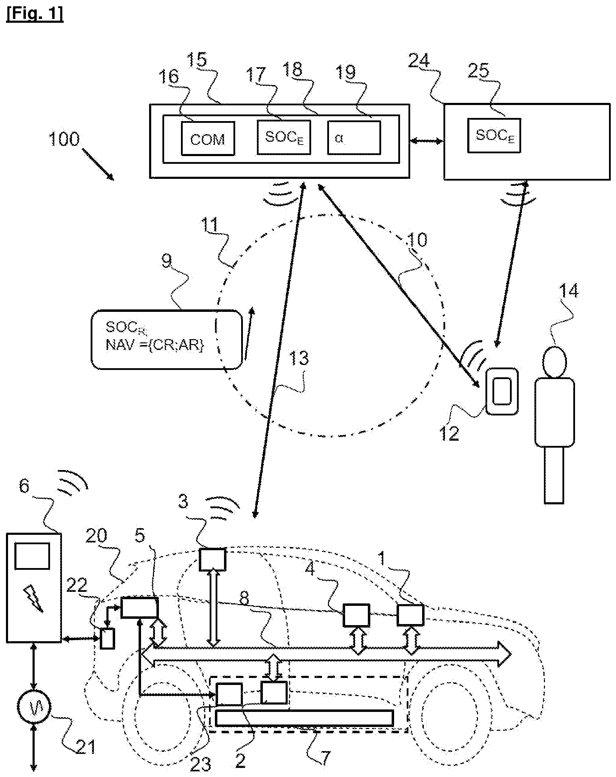

Plus précisément, la figure 1 décrit un système de supervision distante 100 d'une recharge électrique d'un véhicule électrifié 20. Le système 100 comporte au moins une borne de recharge électrique 6 à partir d'un réseau d'alimentation électrique 21, de courant alternatif, un équipement de supervision distante 15 communiquant des données avec un véhicule connecté à travers un réseau étendu de communication sans fil 11, par exemple un réseau de téléphonie cellulaire de type « 3G », « 4G » ou « 5G ». Un tel réseau est adapté pour la communication de données entre équipements connectés distants avec une portée de plusieurs centaines de kilomètres et permet la transmission de données par protocole IP.

Le véhicule 20 est équipé d'un système de batterie de puissance comprenant une batterie électrique de haute tension 7, généralement de plusieurs centaines de volts, assurant la fourniture d'énergie électrique à une machine électrique de traction du véhicule 20. La batterie électrique comprend des cellules électriques, par exemple de type Lithium-ion. Le système de batterie comprend également un calculateur 2 de gestion du système de batterie adapté pour superviser les paramètres spécifiques à la batterie 7 en coopération avec des capteurs de courant et tension, tels l'état de charge SOC (« State of Charge ») exprimé classiquement en pourcentage de charge de la capacité totale de la batterie, la tension de circuit ouvert OCV (« Open Circuit Voltage ») exprimée en Volt, le courant de charge exprimé en Ampère, l'état de santé SOH (« State of Health) exprimé en pourcentage de capacité de la capacité initiale à l'état neuf de la batterie.

Le véhicule 20 comprend en outre des moyens de conversion électrique embarqués 5 de type courant alternatif/courant continu dit « AC/DC » et une prise de courant 22 permettant de connecter le véhicule à une borne de recharge. Des connecteurs de commutation 23 assurent la déconnexion/connexion de la batterie 7 avec le circuit électrique de puissance du véhicule et avec le convertisseur 5.

La borne de recharge électrique 6 peut être une prise conventionnelle domestique sur laquelle se branche le câble de recharge du véhicule, telle une prise électrique privée, ou être une borne de recharge personnelle, appartenant à l'utilisateur et disposée à son domicile ou à un stationnement privé. Dans ce cas d'exemple, la prise n'est pas prévue pour coopérer avec un système tiers opéré par un fournisseur de recharge électrique. Alternativement la borne de recharge 6 peut être une borne connectée à un système tiers opéré par un fournisseur de recharge supervisant un parc de bornes de recharge. La borne est alors adaptée pour transmettre des données à travers le système de supervision du fournisseur.

Pour communiquer avec le réseau étendu de communication 11, le véhicule 20 comporte en outre des moyens de communications sans fil 3, désigné également par les acronymes BTA et BSRF, comprenant notamment un dispositif à antenne, un boitier télématique, par exemple à carte SIM ( pour « Subscriber Identity Module »), permettant d'identifier et d'authentifier le véhicule auprès d'un fournisseur de service à travers le réseau de communication 11 afin d'autoriser la communication de données entre l'équipement de supervision distante 15 et le véhicule 20. Les moyens de communications sans fil 3 sont adaptés pour réveiller les calculateurs du véhicule lorsque ceux-ci sont éteints ou endormis. A cet effet, le boitier télématique peut rester en état de veille permettant un réveil à distance pour l'exécution d'un service distant, par exemple au moyen du protocole MQTT.

Le véhicule comporte en outre un calculateur principal 1, désigné également par les acronymes VSM, BSI ou bien encore VCU ayant pour fonction de centraliser les fonctions et les communications de données avec les calculateurs secondaires du véhicule, tels le calculateur 2 du BMS, le boitier télématique 3. Le calculateur principal et les calculateurs secondaires coopèrent à travers un réseau de communication de donnée embarqué filaire 8, par exemple de type CAN. L'ensemble des calculateurs sont alimentés par des circuits d'alimentation (non représentés) pilotés par des commutateurs de puissance, ou relais électriques. Lorsque le véhicule est éteint ou endormis, notamment en attente d'une recharge électrique, ou lors d'une session d'une recharge électrique, la stratégie du véhicule mise en œuvre par le calculateur principal 1 est d'éteindre les calculateurs pour éviter une consommation électrique excessive.

De plus, le véhicule comporte en outre un calculateur secondaire 4 d'infodivertissement dédié à la fourniture de données de navigation et de média à bord du véhicule, couramment désigné par le terme calculateur « infotainment ». Il communique avec les autres calculateurs du véhicule à travers le réseau 8 CAN. Classiquement, il coopère avec une unité de visualisation ou unité multimédia à bord du véhicule pour transmettre des données relatives à du média et de la navigation de bord. Plus précisément, le calculateur 4 utilise des données de navigation NAV, destinées à être affichées à bord du véhicule, incluant un paramètre de vitesse de recharge CR exprimé en kilomètres d'autonomie rechargés par heure de recharge électrique (km/h) et une autonomie résiduelle AR de roulage exprimée en kilomètre (km). Ces données sont affichées à l'utilisateur à bord du véhicule lors d'une session de recharge.

Dans le cadre de l'invention, le calculateur 4 est adapté pour communiquer ces données de navigation NAV à travers le réseau CAN à destination du calculateur principal 1 et pour transmettre lesdites données via le boitier télématique 3 à l'équipement de supervision distante 15. Ces données de navigation NAV sont particulièrement intéressantes car elles sont aptes à être communiquées vers un équipement déporté du véhicule, tel l'équipement de supervision 15, quelle que soit l'architecture électrique et de réseau de bord du véhicule. Elles permettent en outre de déterminer une valeur de courant de recharge moyenne en cours d'une session de recharge et une durée de recharge restante. Les données de navigation NAV permettent en outre à l'équipement de supervision 15 d'estimer un état de charge lors d'une session de recharge sans besoin de collecter des données auprès du véhicule.

Par ailleurs, selon les constructeurs de véhicules certaines données du BMS peuvent être réservées à un usage strictement embarqué, c'est-à-dire limité aux systèmes du groupe motopropulseur du véhicule. La valeur du courant de charge et le mode de recharge ne sont pas toujours accessibles pour un équipement de supervision distante 15. De même, dans le cas d'une prise de recharge conventionnelle, ou lorsque la borne de recharge n'est pas connectée à un fournisseur de recharge, l'équipement de supervision 15 n'est pas nécessairement en possibilité de connaitre la valeur de courant de charge et le mode de recharge. Ainsi, l'usage des données de navigation NAV selon la mise en œuvre de l'invention améliore l'interopérabilité du procédé d'estimation de l'état de charge.

L'équipement de supervision distante 15 comprend un système logiciel 18 de supervision distante de véhicules connectés opérant un service de connectivité et de traitement de données d'un parc de véhicules connectés (souvent désigné par « Cloud Service », service en ligne ou service dans les nuages) adapté pour communiquer avec le véhicule 20 via le réseau de communication sans fil 11. A cet effet, il comprend en outre des moyens de communications sans fil (non représenté) permettant d'établir un canal de communication de données depuis et vers l'équipement de supervision. Le service de connectivité est par exemple opéré par le constructeur du véhicule électrifié 20. Le système logiciel 18 se base sur un ou plusieurs serveurs distants de l'équipement 15. Un serveur comprend un processeur et un dispositif de stockage de données et des dispositifs matériels conventionnels tels des interfaces réseau et autres modules logiciels d'interface. Le processeur comprend une ou plusieurs unités de traitement de données et des mémoires volatiles et non-volatiles pour l'exécution de programmes informatiques.

Le module logiciel 18 comprend un module de communication 16 adapté pour établir un canal de communication 13 de données 9 entre le véhicule 20 et l'équipement de supervision 15 à travers le réseau de communication sans fil 11. En particulier dans le cadre de l'invention, le module de communication 16 est adapté pour réveiller et éteindre les calculateurs du véhicule selon des critères spécifiques de réveil en vue d'établir une communication de données, pour déclencher à distance une session de recharge électrique du véhicule, pour établir une communication de données en début de recharge et fin de recharge électrique, et entre le début et la fin d'une session de recharge.

En outre, le module de communication 16 est adapté pour établir un canal de communication 10 de données entre un dispositif électronique personnel 12 d'un utilisateur 14 et l'équipement de supervision 15 à travers le réseau de communication sans fil 11, notamment pour recevoir des requêtes utilisateur et transmettre des données directement à l'utilisateur 14. Le dispositif personnel 12 est un téléphone portable, tablette, montre connectée ou ordinateur par exemple. Le dispositif personnel 12 est adapté pour opérer une application du constructeur du véhicule pour des services distants propriétaires du constructeur.

Le module logiciel 18 comprend en outre un module estimateur 17 dont la fonction est d'estimer une valeur d'état de charge $SOC_E$ à partir d'une équation d'estimation utilisant les données communiquées 9 provenant du véhicule 20, notamment l'état de charge effectif $SOC_R$ et les données de navigation NAV incluant la vitesse de recharge CR et l'autonomie résiduelle AR. L'équation d'estimation sera décrite plus précisément dans la suite de la description.

Le module logiciel 18 gère en outre une base de données 19 d'un coefficient de correction $\alpha$ utilisé par l'équation d'estimation. La base de données répertorie pour chaque véhicule indexé un coefficient de correction $\alpha$. Le coefficient de correction est préétabli en fonction de critère spécifique au constructeur, la zone géographique, le modèle de véhicule par exemple. Dans un cas d'exemple, sa valeur d'initialisation est 1, puis durant l'usage du véhicule le coefficient de correction évoluera en fonction des conditions d'utilisation, notamment en recharge. Le calcul du coefficient de correction sera décrit plus précisément dans la suite de la description.

Enfin, le système 100 est prévu pour coopérer avec un système tiers 24 d'un fournisseur de service. L'équipement distant 15 et le système tiers 24 coopèrent en communication de données pour l'échange des valeurs d'état de charge estimé $SOC_E$, et comprend un moyen d'enregistrement de l'état de charge estimé $SOC_E$ calculé par l'équipement de supervision 15 à tout instant, ainsi qu'un système logiciel 25 adapté à opérer un service distant exploitant le $SOC_E$. Le système tiers 24 se base sur un ou plusieurs serveurs distants et bases de données. Un serveur comprend un processeur et un dispositif de stockage de données et des dispositifs matériels conventionnels tels des interfaces réseau et autres modules logiciels d'interface. Le processeur comprend une ou plusieurs unités de traitement de données et des mémoires volatiles et non-volatiles pour l'exécution de programmes informatiques.

Le fournisseur de service 24 peut être un opérateur de bornes de recharge (la borne de recharge 6 par exemple) permettant la gestion de recharge intelligente à distance ou un opérateur de gestion énergétique d'un réseau d'alimentation électrique (EMS pour « Energy Management System ») opérant des services de gestion intelligente du réseau d'alimentation électrique, un serveur dudit opérateur hébergeant un module logiciel de gestion énergétique dudit réseau d'alimentation électrique. Alternativement le fournisseur de service peut être un opérateur d'une flotte de véhicule ou un fournisseur de services à l'utilisateur 14, par exemple un service reposant sur une application pour l'usage de son véhicule, une application de navigation, une application de gestion de données et d'appareils connectés du domicile, tels la borne de recharge 6 domestique, un compteur électrique, etc. Le système tiers 24 peut communiquer avec un ou des appareils connectés à travers le réseau de communication sans fil ou un réseau IP filaire ou par réseau de fibre optique ou satellite, c'est à dire via un fournisseur de service internet qui n'est pas nécessairement un réseau de téléphonie mobile.

On précise une nouvelle fois l'avantage de l'usage des données de navigation NAV du véhicule pour estimer le $SOC_E$ car le procédé assure une meilleure interopérabilité pour calculer le $SOC_E$. En effet, le calcul du $SOC_E$ est possible à partir de données issues uniquement du véhicule et est ainsi indépendant d'une coopération avec un opérateur d'un réseau de borne de recharge connectée.

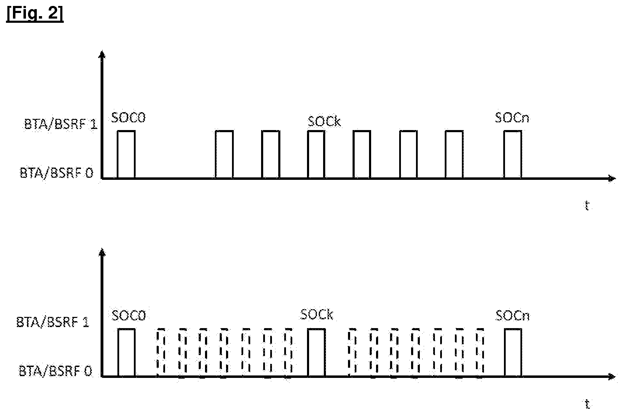

On décrit maintenant la mise en œuvre du procédé d'estimation de l'état de charge selon l'invention. En figure 2, on a illustré sur le graphique supérieur une session de recharge de la batterie du véhicule électrifié selon l'état de la technique et sur le graphique inférieur la mise en œuvre du procédé selon l'invention. Durant la session de recharge un utilisateur ou un programme distant d'un opérateur tiers consulte périodiquement l'état de charge de la batterie. On a représenté sur l'axe vertical un état binaire des moyens télématiques du véhicule BTA/BSRF représentant à l'état 1 un état de réveil et à l'état 0 un état d'endormissement des systèmes. Sur l'axe horizontal est représenté le temps durant la session de recharge. Au déclenchement de la session de recharge, une première communication de données entre l'équipement de supervision et le véhicule permet l'échange de la valeur de l'état de charge effectif $SOC_0$ et en fin de recharge une dernière communication permet l'échange de la valeur de l'état de charge effectif $SOC_n$.

Selon les techniques connues de l'art antérieur, à chaque requête d'état de charge de la batterie $SOC_k$, l'équipement de supervision réveille les systèmes du véhicule. La valeur d'état de charge est actualisée à chaque réveil par les valeurs envoyées depuis le véhicule. Ce sont les rectangles en trait continu sur le graphique du haut. Cette séquence provoque un vieillissement accéléré des commutateurs électroniques du véhicule et n'est pas souhaitée.

Selon l'invention, durant la session de charge un état de charge estimé est calculé continuellement par l'équipement de supervision distante à partir des données transmises $SOC_0$ lors du déclenchement de la session de recharge. Ce sont les rectangles en trait discontinu. L'état de charge estimé est déterminé continuellement à partir des valeurs effectives transmises par le véhicule en début de recharge, en fin de recharge et à un unique instant $SOC_k$ entre le début et la fin de recharge selon un critère de recalage déterminé par l'équipement de supervision. Chaque réveil des systèmes électroniques du véhicule déclenche un recalage du SOC estimé à la valeur du SOC effectif, ainsi que du facteur de correction. Ce sont les rectangles en trait continu. Dans un cas d'exemple, ce recalage est commandé lorsque la durée de recharge atteint environ la moitié de la durée totale de charge planifiée, ou lorsque le niveau d'état de charge de la batterie atteint la moitié de la capacité maximale de la batterie. Comme cela est visible sur la figure 2, l'invention diminue drastiquement le nombre de réveil des systèmes.

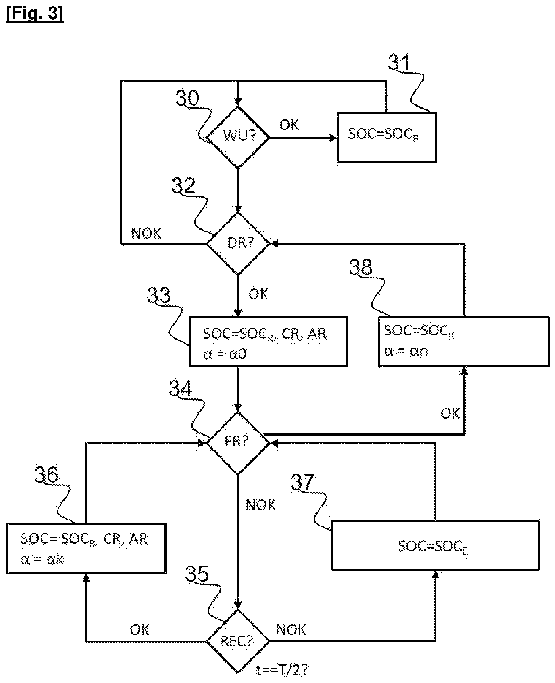

En figure 3, on a représenté un diagramme illustrant un mode de réalisation d'une session de recharge durant laquelle l'équipement de supervision distante exécute le procédé selon l'invention pour estimer l'état de charge de la batterie du véhicule électrifié. L'équipement de supervision est muni d'un calculateur à circuits intégrés et de mémoires électroniques, le calculateur et les mémoires étant configurés pour exécuter le procédé selon l'invention. Mais cela n'est pas obligatoire. En effet, le calculateur pourrait être externe à l'équipement de supervision, tout en étant couplé à ce dernier. Dans ce dernier cas, il peut être lui-même agencé sous la forme d'un calculateur dédié comprenant un éventuel programme dédié, par exemple. Par conséquent, le calculateur, selon l'invention, peut être réalisé sous la forme de modules logiciels (ou informatiques (ou encore « software »)), ou bien de circuits électroniques (ou « hardware »), ou encore d'une combinaison de circuits électroniques et de modules logiciels.

Durant cette session une première vérification 30 est exécutée durant laquelle l'équipement de supervision contrôle si les moyens de communication sans fil du véhicule, BTA et BSRF, et le calculateur principal VSM sont réveillés. Ce contrôle est exécuté en surveillant par exemple l'état des trames de communications entre le véhicule et l'équipement distant. Par exemple, on surveille la fréquence des trames envoyées du véhicule vers l'équipement de supervision à travers le réseau de communication sans fil, on compare cette fréquence avec une fréquence prédéterminée représentative d'un état de réveil des systèmes, une par minute par exemple.

Si l'équipement de supervision détecte que les systèmes du véhicule sont réveillés, alors l'équipement de supervision collecte, à une étape 31, les valeurs effectives $SOC_R$ de l'état de charge de la batterie via le réseau de communication sans fil selon une fréquence de mise à jour prédéterminée de période constante, par exemple toutes les quinze minutes environ. La fréquence de mise à jour de l'état de charge peut être supérieure ou inférieure et adaptée selon les besoins de l'équipement de supervision et d'un opérateur tiers. On prévoit que la mise à jour de l'état de charge puisse être effectuée à la demande par un utilisateur, indépendamment de la fréquence prédéterminée. Entre deux mises à jour, la valeur de l'état de charge fournie par l'équipement de supervision est constante.

Dans le cadre d'une session de recharge, l'étape 30 peut consister à vérifier si le véhicule opère un pré-conditionnement thermique du système de batterie préalablement à la recharge, ou si l'équipement de supervision distante commande à distance un pré-conditionnement thermique préalable à la recharge électrique. Lors d'un pré-conditionnement thermique, les systèmes du véhicule sont réveillés et l'équipement de supervision peut détecter l'opération, au moyen par exemple d'un signal de contrôle échangé entre le véhicule et l'équipement de supervision. Un programme de recharge planifié mis en œuvre par l'équipement de supervision peut comprendre également une instruction de pré-conditionnement thermique, auquel cas cette instruction déclenche également la collecte des valeurs effectives de l'état de charge $SOC_R$ selon la fréquence de mise à jour prédéterminée.

Ensuite, éventuellement à la suite de l'opération de pré-conditionnement thermique, l'équipement de supervision passe à une étape de surveillance 32 durant laquelle on détermine si une recharge électrique est déclenchée. Si une condition DR de déclenchement de recharge n'est pas détectée, le procédé poursuit la surveillance 30. La condition DR peut être l'état d'activation d'un signal de contrôle d'une recharge électrique. Le signal peut être un signal du véhicule, un signal de l'équipement de supervision ou bien encore un signal issu de la borne de recharge ou d'un fournisseur de recharge électrique. Lors du déclenchement de la recharge électrique, les systèmes du véhicule sont réveillés.

En cas de détection de la condition DR de déclenchement d'une session de recharge, à l'étape 33 le procédé comprend une première communication de données 33 dudit véhicule électrifié vers l'équipement de supervision. Ladite communication de données comprend les données communiquées incluant des premières valeurs de l'état de charge effectif de la batterie $SOC_R$ et les paramètres de navigation NAV du véhicule représentatifs d'une vitesse de recharge CR et d'une autonomie résiduelle AR de roulage à l'instant de ladite première communication. Les paramètres de navigation sont issus du calculateur d'infodivertissement, le calculateur appelé « calculateur infotainment ». La communication de données peut comprendre d'autres informations, telles un identifiant de véhicule, un identifiant utilisateur, un état de santé de la batterie, la température dans l'environnement proche du véhicule, etc.

Lors de cette étape 33, l'équipement de supervision détermine en outre la valeur du facteur de correction $\alpha_0$ à l'instant $t_0$ du déclenchement de la recharge. La valeur est déterminée à partir des valeurs contenues dans la base de données 19 en référence à la figure 1. La valeur initiale est égale à 1 pour la première recharge électrique supervisée. La valeur varie ensuite en fonction de l'historique des recharges du véhicule et de la mise à jour du facteur de correction $\alpha$ au cours des recharges. La valeur $\alpha 0$ peut éventuellement être déterminée par un algorithme d'intelligence artificielle en fonction des données transmises lors de l'étape 33, à partir de données d'identification utilisateur, d'une température extérieure dans l'environnement du véhicule, de l'état de santé de la batterie le cas échéant.

A une étape 34, le procédé comporte une étape de surveillance de la fin de la session de recharge FR. La condition de fin de recharge FR peut être l'état d'activation d'un signal de contrôle d'une recharge électrique. Le signal peut être un signal du véhicule, un signal de l'équipement de supervision ou bien encore un signal issu de la borne de recharge ou d'un fournisseur de recharge électrique. Durant la session de recharge, le calculateur principal et les calculateurs du boitier télématique du véhicule sont éteints pour limiter la consommation d'énergie notamment. Le canal de communication 13 n'est pas habilité pour la transmission de données.

A une étape 35, le procédé comporte une étape de vérification d'une condition REC de déclenchement d'une session de recalage de la valeur de l'état de charge estimé et du facteur de correction $\alpha$. La vérification de la condition REC est une durée de recharge écoulée depuis l'instant de détection t0 de déclenchement de la recharge que l'on compare à une durée prédéterminée, où la durée prédéterminée est égale à la moitié de la durée totale de recharge de la batterie par exemple. La durée totale de recharge prévue est estimée dans ce cas d'exemple à partir des données de navigation NAV transmises lors de la communication de données. En effet, ces données comprennent une vitesse de recharge et une autonomie résiduelle de roulage permettant d'estimer une durée totale de recharge $t_{total\_charge}$ selon la relation suivante :

[Math 2]

$$t_{total\_charge} = \frac{AR}{SOC_R(t_0) * CR} * (100 - SOC_R(t_0))$$

Où $SOC_R(t0)$ est la valeur effective collectée par l'équipement de supervision à un instant $t_0$ antérieur à $t_n$ exprimée en %, CR est la vitesse de recharge, AR est l'autonomie résiduelle de roulage. CR peut être exprimé en km/h, km d'autonomie rechargés par heure de recharge, et AR en km.

En variante, la condition de déclenchement de la session de recalage est une quantité d'énergie rechargée par rapport à la capacité totale de la batterie.

Si la condition de recalage n'est pas détectée, par exemple le temps écoulé est inférieur à la durée prédéterminée, conformément au procédé selon l'invention, à une étape 37 l'équipement de supervision distante estime une valeur de l'état de charge $SOC_E$ à partir desdites données communiquées au déclenchement de la recharge électrique et à partir du facteur de correction $\alpha$ de la vitesse de recharge enregistrée en mémoire de la base de données. La valeur estimée $SOC_E$ est calculée en continu par l'équipement de supervision.

Plus précisément, la valeur $SOC_E$ est calculée à partir d'une équation d'estimation égale à la relation suivante :

[Math 3]

$$SOC_E(t_n) = SOC_R(t_0) + \alpha 0 * \frac{(t_n - t_0) * CR * SOC_{reel}(t_0)}{AR * 3600}$$

Où:

$SOC_E(t_n)$ est la valeur estimée de l'état de charge à un instant tn exprimé en secondes, $SOC_R(t0)$ est la valeur effective collectée par l'équipement de supervision à l'instant t0 de déclenchement de la recharge, $\alpha 0$ est le facteur de correction enregistrée dans la base de données, CR est un paramètre représentatif du courant de charge déterminé à partir de la vitesse de recharge, AR est le paramètre représentatif d'une capacité de roulage restante calculé à partir de l'autonomie résiduelle de roulage. Cr peut être exprimé en km/h, km d'autonomie rechargés par heure de recharge, et AR en km. 3600 réalise la conversion entre l'unité de temps « heure » et l'unité de temps « seconde ».

CR peut être un courant de charge moyen, exprimé en Ampère, calculé à partir du paramètre de navigation exprimée en vitesse de recharge. Dans ce cas, AR peut être une capacité résiduelle de la batterie exprimée en Ampères-heures qui est calculée à partir de l'autonomie résiduelle exprimée en km.

On ajoutera que la valeur de capacité de roulage distante AR peut être fonction d'un paramètre d'état de santé SOH de la batterie. Ce paramètre SOH peut être transmis par le véhicule lors de la communication de donnée, ou peut être déterminé par l'équipement de supervision. La valeur SOH est égale à 1 pour un état « neuf » de la batterie et diminue lors du vieillissement de la batterie.

La valeur $SOC_E$ est consultable en continu par un fournisseur de service connecté à l'équipement de supervision, ou par un utilisateur du véhicule par l'intermédiaire d'un dispositif électronique personnel. L'avantage du procédé est qu'il permet de fournir une valeur de $SOC_E$ sans besoin de réveiller le véhicule sur requête d'un système tiers à tout instant. On réduit ainsi les commutations de réveil. L'estimation en continu signifie que la valeur $SOC_E$ est mise à jour selon un deuxième mode différent du mode de l'étape 31, avec une fréquence de mise à jour supérieure, par exemple à chaque minute ou chaque seconde éventuellement.

Le procédé prévoit selon l'invention une unique session de recalage entre le déclenchement et la fin de la recharge. Si la condition de recalage est détectée à l'étape 35, c'est-à-dire que le temps écoulé est égal à environ la moitié du temps de recharge prévu, à une étape 36, l'équipement de supervision distante déclenche une session de recalage de la valeur du $SOC_E$ et de la valeur du facteur de correction $\alpha$ à un instant donné $t_k$. La session de recalage implique le réveil à distance des calculateurs du véhicule par l'équipement de supervision, par exemple conformément au protocole MQTT connu de l'homme du métier.

Une fois les calculateurs réveillés, l'étape 36 comporte une communication de données depuis le véhicule vers l'équipement de supervision comprenant les valeurs, à l'instant de ladite communication $t_k$, de l'état de charge effectif de la batterie $SOC_R$ et les paramètres de navigation NAV incluant la vitesse de recharge CR et l'autonomie résiduelle AR de roulage.

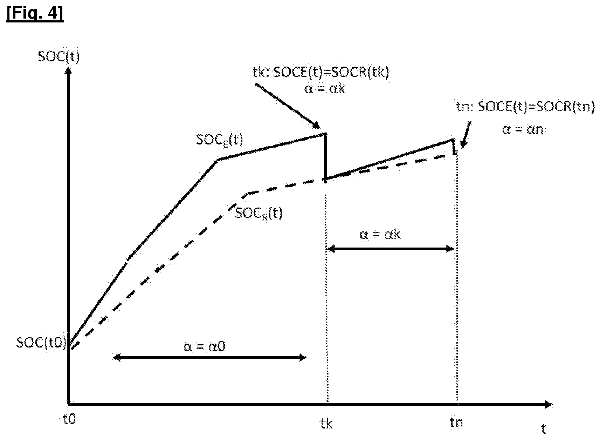

La valeur $SOC_E$ est recalée à la valeur $SOC_R$ effective obtenue du véhicule. Ce recalage est illustré en figure 4 dans laquelle un graphique représente schématiquement durant une session de recharge électrique les valeurs de SOC pour le $SOC_E$ estimé par l'équipement de supervision en trait continu et pour le $SOC_R$ effectif calculé en embarqué par le BMS du véhicule. Le $SOC_E$ est calculé en continu par l'équipement de supervision et est la valeur fournie à un système de fournisseur de service ou à un utilisateur durant la session de recharge. En abscisse est représenté le temps, $t_0$ correspond au déclenchement de la recharge électrique, $t_k$ à l'instant de la commande d'une session de recalage en cour de recharge et $t_n$ l'instant de fin de recharge.

En outre, la session de recalage 36 comporte le calcul d'une nouvelle valeur $\alpha_k$ du facteur de correction $\alpha$ et la mise à jour de la valeur enregistrée dans la base de données pour des estimations ultérieures de l'état de charge. Plus précisément, à la session de recalage en milieu de la recharge électrique, le facteur de correction $\alpha_k$ est calculé selon l'équation suivante :

[Math 4]

$$\alpha k = \frac{SOC_R(t_k) - SOC_R(t_0)}{SOC_E(t_k) - SOC_R(t_0)} * \alpha 0$$

Où : $t_k$ est l'instant de la session de recalage, t0 est l'instant de déclenchement de la session de recharge électrique, $SOC_E$ l'état de charge estimé et $SOC_R$ l'état de charge effectif.

Entre $t_0$ et $t_k$, le facteur de correction dans la base de données est égal à $\alpha_0$. A l'instant $t_k$, la valeur $SOC_E$ est recalée à la valeur $SOC_R$.

A la suite de l'instant de recalage $t_k$ et jusqu'à la fin de la recharge à l'instant $t_n$, les calculateurs du véhicule sont éteints. Les valeurs $SOC_E$ sont calculées à l'étape 37 par l'équipement de supervision conformément à l'équation d'estimation précédente où $\alpha = \alpha_k$ et les valeurs effectives du $SOC_R$ sont remplacées par les dernières valeurs communiquées du véhicule lors de la session de recalage à l'instant $t_k$.

Ainsi, à chaque instant $t_n$ postérieur à $t_k$, les valeurs $SOC_E$ sont calculées selon la formule suivante :

[Math 5]

$$SOC_E(t_n) = SOC_R(t_k) + \alpha k * \frac{(t_n - tk) * CR * SOC_R(tk)}{AR * 3600}$$

Enfin, en cas de détection à l'étape 34 de la condition FR de fin de recharge, le procédé selon l'invention comporte l'étape 38 durant laquelle une dernière session de recalage est commandée par l'équipement de supervision. La fin de recharge implique le réveil des calculateurs du véhicule. Une fois les calculateurs réveillés, cette étape 38 comporte une nouvelle communication de données depuis le véhicule vers l'équipement de supervision comprenant les valeurs, à l'instant de ladite communication $t_n$, de l'état de charge effectif de la batterie $SOC_R$.

A l'instant $t_n$ de fin de recharge, la valeur du $SOC_E$ est recalée à la valeur $SOC_R$ communiquée lors de la dernière communication de données comme cela est visible en figure 4. La valeur du $SOC_E$ est communiquée à un système tiers en cas de requête à tout instant.

De même, le facteur de correction $\alpha$ est mis à jour en fin de recharge électrique à une nouvelle valeur $\alpha_n$ selon la formule suivante :

[Math 6]

$$\alpha n = \frac{SOC_R(t_n) - SOC_R(t_k)}{SOC_E(t_n) - SOC_R(t_k)} * \alpha k$$

La valeur $\alpha_n$ est enregistrée en mémoire de la base de données pour les calculs des valeurs de $SOC_E$ de la session de recharge suivante du véhicule.

Une fois que le recalage de fin de recharge est effectué, le procédé retourne à l'étape 32 où on vérifie si le véhicule opère une recharge électrique. Dans la négative, le procédé retourne à l'étape de vérification initiale de pré-conditionnement thermique.

On envisage que la session de recharge ne comporte pas de session de recalage, la valeur $SOC_E$ est alors calculée durant toute la session de recharge en fonction des données communiquées au déclenchement de la recharge à l'instant $t_0$ et en fonction du facteur de correction $\alpha_0$.

**Revendications**

1. Procédé d'estimation de l'état de charge d'une batterie électrique (7) d'un véhicule électrifié (20) mis en œuvre dans un système de supervision (100) de véhicules électrifiés comprenant des moyens de recharge électrique (6) reliés à un réseau d'alimentation électrique (21) et assurant une recharge électrique de ladite batterie électrique (7), au moins un équipement de supervision distante (15) hébergeant un système logiciel de supervision distante (18) de véhicules connectés et un réseau étendu de communication sans fil (11), le véhicule (20) comprenant un dispositif de communication sans fil (3) adapté pour transmettre des données à l'équipement de supervision distante (15) à travers ledit réseau (11) et un calculateur d'infodivertissement (4) prévu pour la fourniture de paramètres de navigation (NAV) à bord du véhicule, ce procédé comprenant, en début d'une session de recharge électrique une première communication de données (33) dudit véhicule électrifié (20) vers l'équipement de supervision (15), ladite première communication de données (33) comprenant des données communiquées (9) incluant des premières valeurs d'un état de charge effectif (SOCR) de ladite batterie (7) et des paramètres de navigation (NAV) issus du calculateur (4) et représentatifs d'une vitesse de recharge (CR) et d'une autonomie résiduelle (AR) de roulage à l'instant de ladite première communication, **caractérisé en ce qu'**il comprend en outre, pendant ladite session de recharge électrique, une estimation et une fourniture (37) d'un état de charge estimé (SOCE) par ledit équipement de supervision (15), ledit état de charge estimé (SOCE) étant déterminé à partir desdites données communiquées (9) et d'une première valeur $\alpha 0$ d'un facteur de correction $\alpha$ de la vitesse de recharge, ladite première valeur $\alpha 0$ étant enregistrée dans une base de données (19) de l'équipement de supervision (15), l'estimation de l'état de charge estimé étant calculée à partir d'une équation d'estimation égale à la relation suivante :

[Math        1]

$$SOC_E(t_n) = SOC_R(t_0) + \alpha * \frac{(t_n - t_0) * CR * SOC_R(t_0)}{AR * 3600}$$

Où :

   - $SOC_E(tn)$ est la valeur estimée de l'état de charge à un instant tn,
   - $SOC_R(t0)$ est la valeur effective collectée par l'équipement de supervision à un instant t0 antérieur à tn,
   - $\alpha$ est le facteur de correction enregistrée dans la base de données,
   - CR est un paramètre représentatif du courant de charge déterminé à partir de la vitesse de recharge,
   - AR est le paramètre représentatif d'une capacité de roulage restante calculée à partir de l'autonomie résiduelle de roulage.

2. Procédé selon la revendication 1, **caractérisé en ce que** les paramètres de navigation (NAV) incluent une vitesse de recharge dont la valeur est exprimée en autonomie de roulage par heure de recharge et une autonomie résiduelle dont la valeur est exprimée en distance de roulage.

3. Procédé selon la revendication 1 ou 2, **caractérisé en ce qu'**il comporte en outre, durant la session de recharge électrique, au moins une séquence de recalage (36) de l'état de charge estimé (SOC$_E$) et du facteur de correction $\alpha$ comprenant les étapes successives suivantes :

- Une deuxième communication de données dudit véhicule électrifié (20) vers l'équipement de supervision (15) comprenant des deuxièmes valeurs desdites données communiquées (9) à l'instant de la deuxième communication,
- Le recalage de l'état de charge estimé (SOC$_E$) à partir desdites deuxièmes valeurs,
- Le calcul d'une deuxième valeur $\alpha_k$ du facteur de correction $\alpha$ et la mise à jour de la valeur enregistrée dans la base de données pour des estimations de l'état de charge (SOC$_E$) ultérieurement à l'instant de la deuxième communication.

4. Procédé selon la revendication 3, **caractérisé en ce qu'**au moins ladite séquence de recalage (36) est déclenchée en cas de détection d'une durée de charge écoulée qui est égale à environ à la moitié de la durée de recharge totale planifiée de la session de recharge.

5. Procédé selon l'une quelconque des revendications 1 à 4, **caractérisé en ce qu'**il comporte en outre, en cas de détection d'une fin de la session de recharge :

- Une troisième communication de données dudit véhicule électrifié vers l'équipement de supervision incluant la valeur de l'état de charge effectif (SOC$_R$) de ladite batterie (7) à l'instant de la fin de la session de recharge,
- Le recalage (38) de l'état de charge estimé (SOC$_E$) à partir de ladite valeur de l'état de charge effectif,
- Le calcul d'une troisième valeur $\alpha_n$ du facteur de correction $\alpha$ et la mise à jour de la valeur enregistrée dans la base de données (19) pour des estimations de l'état de charge (SOC$_E$) ultérieurement à l'instant de la fin de session de recharge.

6. Procédé selon l'une quelconque des revendications 1 à 5, **caractérisé en ce que** la session de recharge comporte en outre une phase de pré-conditionnement thermique (31) de la batterie (7) durant laquelle l'équipement de supervision (15) collecte à travers le réseau de communication sans fil (11) des valeurs de l'état de charge effectif (SOC$_R$) de ladite batterie (7) selon une fréquence prédéterminée et/ou en réponse à une requête pour la fourniture desdites valeurs.

7. Procédé selon l'une quelconque des revendications 1 à 6, **caractérisé en ce que** le procédé comporte en outre la fourniture de la valeur de l'état de charge estimé (SOC$_E$) par l'équipement de supervision (15) à un dispositif électronique personnel (12) d'un utilisateur du véhicule (20) à travers le réseau de communication sans fil (11).

8. Procédé selon l'une quelconque des revendications 1 à 7, **caractérisé en ce que** le procédé comporte en outre la fourniture de la valeur de l'état de charge estimé (SOC$_E$) par l'équipement de supervision (15) à un serveur informatique d'un fournisseur de service tiers.

9. Equipement de supervision distante (15) comportant un dispositif de stockage de données mémorisant des instructions de programme mettant en œuvre le procédé d'estimation de l'état de charge d'une batterie électrique d'un véhicule électrifié selon l'une quelconque des revendications 1 à 8.

**Patentansprüche**

1. Verfahren zum Schätzen des Ladezustands einer elektrischen Batterie (7) eines Elektrofahrzeugs (20), das in einem Überwachungssystem (100) für Elektrofahrzeuge implementiert ist, das elektrische Auflademittel (6) umfasst.

an ein elektrisches Stromversorgungsnetz (21) angeschlossen ist und das elektrische Aufladen der elektrischen Batterie (7) gewährleistet, mindestens eine Fernüberwachungsausrüstung (15), die ein Fernüberwachungssoftwaresystem (18) der angeschlossenen Fahrzeuge und ein drahtloses Weitverkehrskommunikationsnetz (11) beherbergt, wobei das Fahrzeug (20) eine Vorrichtung zum drahtlose
Kommunikation (3), die dazu geeignet ist, Daten über das Netzwerk (11) an die Fernüberwachungsausrüstung (15) zu übertragen, und ein Infotainment-Computer ( 4 ), der für die Bereitstellung von Navigationsparametern (NAV) an Bord des Fahrzeugs vorgesehen ist, wobei dieses Verfahren zu Beginn einer elektrischen Aufladesitzung eine erste Kommunikation von
Daten (33) vom Elektrofahrzeug (20) an die Überwachungsausrüstung (15), wobei die erste Datenkommunikation (33) übermittelte Daten (9) umfasst, darunter erste Werte eines effektiven Ladezustands (SOCR) der Batterie (7) und Navigationsparameter (NAV) vom Computer (4) und repräsentativ für eine Geschwindigkeit von Aufladung (CR) und eine verbleibende Autonomie (AR) des Fahrens zum Zeitpunkt

der ersten Kommunikation, **dadurch gekennzeichnet, dass** es während der elektrischen Aufladesitzung außerdem eine Schätzung und eine Bereitstellung (37) eines geschätzten Ladezustands (SOCE) durch die Überwachungsausrüstung (15) umfasst, wobei der geschätzte Ladezustand (SOCE) bestimmt wird bei aus den übermittelten Daten (9) und aus einem ersten Wert $\alpha 0$ eines Korrekturfaktors a der Aufladegeschwindigkeit, wobei der erste Wert $\alpha 0$ in einer Datenbank (19) der Überwachungseinrichtung (15) aufgezeichnet ist, wird die Schätzung des geschätzten Ladezustands aus einer Schätzgleichung berechnet, die der folgenden Beziehung entspricht:

[Mathematik 7]

$$SOC_E(t_n) = SOC_R(t_0) + \alpha * \frac{(t_n - t_0) * CR * SOC_R(t_0)}{AR * 3600}$$

Oder:

- $SOC_E(t_n)$ ist der geschätzte Wert des Ladezustands zu einem Zeitpunkt $t_n$,
- $SOC_R(t_0)$ ist der von der Überwachungseinrichtung erfasste Effektivwert bei sofort $t_0$ vor $t_n$,
- $\alpha$ ist der in der Datenbank erfasste Korrekturfaktor,
- CR ist ein Parameter, der den aus der Ladegeschwindigkeit ermittelten Ladestrom repräsentiert,
- AR ist der Parameter, der eine berechnete verbleibende Rollkapazität darstellt aus der Restreichweite.

2. Verfahren nach Anspruch 1, **dadurch gekennzeichnet, dass** die Navigationsparameter (NAV) eine Ladegeschwindigkeit umfassen, deren Wert in Fahrautonomie pro Ladestunde ausgedrückt wird, und eine Restautonomie dessen Wert in der Rolldistanz ausgedrückt wird.

3. Verfahren nach Anspruch 1 oder 2, **dadurch gekennzeichnet, dass** es außerdem während der elektrischen Aufladesitzung mindestens eine Neukalibrierungssequenz (36) des geschätzten Ladezustands ($SOC_E$) und des Korrekturfaktors a umfasst, die die folgenden aufeinanderfolgenden Schritte umfasst:

- Eine zweite Datenübermittlung von dem Elektrofahrzeug (20) an Überwachungseinrichtung (15) umfasst zweite Werte der übermittelten Daten (9) zum Zeitpunkt der zweiten Übermittlung,
- Die Neukalibrierung des geschätzten Ladezustands ($SOC_E$) aus den zweiten Werten,
- Berechnung eines zweiten Wertes $\alpha_k$ des Korrekturfaktors $\alpha$ und Aktualisierung des in der Datenbank für Ladezustandsschätzungen (SOCE) aufgezeichneten Werts nach dem Zeitpunkt der zweiten Mitteilung.

4. Verfahren nach Anspruch 3, **dadurch gekennzeichnet, dass** zumindest die Rücksetzsequenz (36) ausgelöst wird, wenn eine Dauer von Ladung, die ungefähr der Hälfte der gesamten geplanten Ladezeit des Ladevorgangs entspricht.

5. Verfahren nach einem der Ansprüche 1 bis 4, **dadurch gekennzeichnet, dass** es im Falle der Erkennung eines Endes der Sitzung von aufladen :

- Eine dritte Übermittlung von Daten vom Elektrofahrzeug an die Überwachungsausrüstung, einschließlich des Wertes des effektiven Ladezustands ($SOC_R$) der Batterie (7) zum Zeitpunkt des Endes des Aufladevorgangs,
- Die Neukalibrierung (38) des geschätzten Ladezustands ($SOC_E$) aus dem Wert von den tatsächlichen Ladezustand,
- Berechnen eines dritten Werts $\alpha_n$ des Korrekturfaktors $\alpha$ und Aktualisieren des in der Datenbank (19) aufgezeichneten Werts für Ladezustandsschätzungen ($SOC_E$) später zum Zeitpunkt des Endes der Ladesitzung.

6. Verfahren nach einem der Ansprüche 1 bis 5, **dadurch gekennzeichnet, dass** dass der Ladevorgang außerdem eine thermische Vorkonditionierungsphase (31) der Batterie (7) umfasst, während der die Überwachungsausrüstung (15) über das drahtlose Kommunikationsnetzwerk (11) Werte des effektiven Ladezustands ($SOC_R$) der Batterie (7) gemäß einem

dieser Werte erfolgt in einer vorgegebenen Häufigkeit und/oder als Reaktion auf eine Anforderung.

7. Verfahren nach einem der Ansprüche 1 bis 6, **dadurch gekennzeichnet, dass** das Verfahren außerdem die Übermittlung des Wertes des geschätzten Ladezustands (SOC$_E$) durch die Überwachungsausrüstung (15) an ein elektronisches Gerät umfasst.
Personal (12) eines Benutzers des Fahrzeugs (20) über das drahtlose Kommunikationsnetzwerk (11).

8. Verfahren nach einem der Ansprüche 1 bis 7, **dadurch gekennzeichnet, dass** das Verfahren außerdem die Übermittlung des Wertes des geschätzten Ladezustands (SOC$_E$) durch die Überwachungsausrüstung (15) an einen Computerserver umfasst.
von einem Drittanbieter-Dienstleister.

9. Fernüberwachungsgerät (15), umfassend ein Datenspeichergerät, das Programmanweisungen speichert, die das Verfahren zur Schätzung des Ladezustands einer elektrischen Batterie eines Elektrofahrzeugs nach einem der Ansprüche 1 bis 8 umsetzen.

## Claims

1. Method for estimating the state of charge of an electric battery (7) of an electrified vehicle (20) implemented in a supervision system (100) of electrified vehicles comprising electric recharging means (6)

   connected to an electrical power supply network (21) and ensuring electrical recharging of said electric battery (7), at least one remote supervision equipment (15) hosting a remote supervision software system (18) of connected vehicles and a wide area wireless communication network (11), the vehicle (20) comprising a device for
   wireless communication (3) adapted to transmit data to the remote supervision equipment (15) through said network (11) and an infotainment computer (4) provided for the provision of navigation parameters (NAV) on board the vehicle, this method comprising, at the start of an electric recharging session, a first communication of data (33) from said electrified vehicle (20) to the supervision equipment (15), said first data communication (33) comprising communicated data (9) including first values of an effective state of charge (SOCR) of said battery (7) and navigation parameters (NAV) from the computer (4) and representative of a speed of
   recharge (CR) and a residual autonomy (AR) of driving at the time of said first communication, **characterized in that** it further comprises, during said electric recharge session, an estimation and a provision (37) of an estimated state of charge (SOCE) by said supervision equipment (15), said estimated state of charge (SOCE) being determined at
   from said communicated data (9) and from a first value $\alpha$ 0 of a correction factor a of the recharging speed, said first value $\alpha$ 0 being recorded in a database (19) of the supervision equipment (15), the estimation of the estimated state of charge being calculated from an estimation equation equal to the following relation:

   [Math 7]

   $$SOC_E(t_n) = SOC_R(t_0) + \alpha * \frac{(t_n - t_0) * CR * SOC_R(t_0)}{AR * 3600}$$

   Or:

   - SOC$_E$(t$_n$) is the estimated value of the state of charge at an instant tn,
   - SOC$_R$(t0) is the effective value collected by the monitoring equipment at a instant tO prior to tn,
   - $\alpha$ is the correction factor recorded in the database,
   - CR is a parameter representative of the charging current determined from the charging speed,
   - AR is the parameter representing a calculated remaining rolling capacity from the residual driving range.

2. Method according to claim 1, **characterized in that** the navigation parameters (NAV) include a recharging speed whose value is expressed in driving autonomy per hour of recharging and a residual autonomy whose value is expressed in rolling distance.

3. Method according to claim 1 or 2, **characterized in that** it further comprises, during the electric recharging session, at least one recalibration sequence (36) of the estimated state of charge ($SOC_E$) and the correction factor a comprising the following successive steps:

- A second communication of data from said electrified vehicle (20) to supervision equipment (15) comprising second values of said communicated data (9) at the time of the second communication,
- The recalibration of the estimated state of charge ($SOC_E$) from said second values,
- Calculation of a second value $\alpha_k$ of the correction factor $\alpha$ and updating of the value recorded in the database for State of Charge Estimates (SOCE) later than the time of the second communication.

4. Method according to claim 3, **characterized in that** at least said resetting sequence (36) is triggered in the event of detection of a duration of
charge which is equal to approximately half of the total planned charging time of the charging session.

5. Method according to any one of claims 1 to 4, **characterized in that** it further comprises, in the event of detection of an end of the session of recharge :

- A third communication of data from said electrified vehicle to the supervision equipment including the value of the effective state of charge ($SOC_R$) of said battery (7) at the time of the end of the recharging session,
- The recalibration (38) of the estimated state of charge ($SOC_E$) from said value of the actual state of charge,
- Calculating a third value $\alpha_n$ of the correction factor $\alpha$ and updating the value recorded in the database (19) for state of charge ($SOC_E$) estimates later at the time of the end of the charging session.

6. Method according to any one of claims 1 to 5, **characterized in that** that the recharging session further comprises a thermal pre-conditioning phase (31) of the battery (7) during which the supervision equipment (15) collects through the wireless communication network (11) values of the effective state of charge ($SOC_R$) of said battery (7) according to a frequency and/or in response to a request for the provision of said values.

7. Method according to any one of claims 1 to 6, **characterized in that** the method further comprises the supply of the value of the estimated state of charge ($SOC_E$) by the supervision equipment (15) to an electronic device. personnel (12) of a user of the vehicle (20) through the wireless communication network (11).

8. Method according to any one of claims 1 to 7, **characterized in that** the method further comprises the supply of the value of the estimated state of charge ($SOC_E$) by the supervision equipment (15) to a computer server. from a third-party service provider.

9. Remote supervision equipment (15) comprising a data storage device storing program instructions implementing the method for estimating the state of charge of an electric battery of an electrified vehicle according to any one of claims 1 to 8.

[Fig. 1]

100

16 15 17 18 19 24 25

COM SOC$_E$ α SOC$_E$

11
9
10

SOC$_R$
NAV ={CR;AR}

13

14

12

6
20 5 3
22
8
4 1

21 23 2 7

[Fig. 2]

EP 4 288 304 B1

[Fig. 3]

**[Fig. 4]**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2101101
- US 20170320398 A1
- US 20160089994 A1
- FR 3065690 A1
- WO 2010033517 A2
- FR 3041782 A1